Europäisches Patentamt

European Patent Office

Office européen des brevets

(11) Veröffentlichungsnummer: **0 232 790**
**A1**

(12) **EUROPÄISCHE PATENTANMELDUNG**

(21) Anmeldenummer: 87101064.1

(22) Anmeldetag: 27.01.87

(51) Int. Cl.4: **G01R 31/28**

(30) Priorität: 06.02.86 DE 3603724

(43) Veröffentlichungstag der Anmeldung:
19.08.87 Patentblatt 87/34

(84) Benannte Vertragsstaaten:
DE FR GB NL

(71) Anmelder: **Siemens Aktiengesellschaft Berlin und München**
**Wittelsbacherplatz 2**
**D-8000 München 2(DE)**

(72) Erfinder: **Brunner, Matthias, Dr.**
**Graf-Andechs-Strasse 30**
**D-8011 Kirchheim(DE)**
Erfinder: **Schmitt, Reinhold, Dipl.-Ing.**
**Josef-Kiefer-Weg 6**
**D-8000 München 83(DE)**
Erfinder: **Winkler, Dieter, Dipl.-Ing.**
**Staudingerstrasse 57**
**D-8000 München 83(DE)**

(54) **Verfahren und Anordnung zur Messung zeitabhängiger Signale mit einer Korpuskularsonde.**

(57) Um hochfrequente Signalverläufe an Knotenpunkten und Leiterbahnen integrierter Schaltungen - (IC) mit guter Zeitauflösung nach dem Sampling-Verfahren zu messen, muß man mit extrem kurzen Primärelektronenpulsen (PE) arbeiten. Bei den mit modernen Strahlaustastsystemen erreichbaren Pulsbreiten werden dann allerdings nur noch einzelne, statistisch auftretende Sekundärelektronen (SE) pro Puls registriert, die am Ausgang eines Energieanalysators (SP,DT,PM) (Spektrometer-Detektoranordnung mit nachgeschaltetem Photomultiplier) Stromimpulse mit unterschiedlicher Amplitude und unterschiedlichem Zeitverhalten erzeugen. Die in konventionellen Anordnungen durchgeführten Strommessungen sind unter diesen Voraussetzungen nur noch mit großem elektronischen Aufwand durchzuführen. Es wird deshalb vorgeschlagen, die Zahl $\Delta N$ der am Ausgang des Energieanalysators (SP,DT,PM) innerhalb eines vorgegebenen Zeitintervalls $\Delta t$ auftretenden Stromimpulse zu bestimmen und den Quotienten $\Delta N/\Delta t$ mit Hilfe einer aus Impulszähler (ZE), Digital-Analog-Wandler (DAC) und Spektrometeransteuerung (SPS) bestehenden Rückkopplungsschaltung durch Nachregeln der Spannung einer Gegenfeldelektrode konstant zu halten.

## Verfahren und Anordnung zur Messung zeitabhängiger Signale mit einer Korpuskularsonde

Die Erfindung betrifft ein Verfahren zur Messung zeitabhängiger Signale mit einer Korpuskularsonde nach dem Oberbegriff des Patentanspruchs 1 sowie eine Anordnung zur Durchführung des Verfahrens nach dem Oberbegriff des Patentanspruchs 6.

Die Überprüfung der Funktionsweise hochintegrierter Schaltungen erfolgt üblicherweise in rechnergesteuerten Testsystemen, in denen man Fehlfunktionen eines Bausteins durch Analyse der in Abhängigkeit von eingespeisten Bitmustern gemessenen Ausgangssignale nachweist. Die so durchgeführten Tests sind aber in den meisten Fällen unvollständig, da man fehlerhafte Schaltungsteile nicht oder nur unter großem Aufwand innerhalb der hochkomplexen Strukturen lokalisieren kann. Deshalb müssen insbesondere während der Entwicklungsphase zusätzliche Messungen im Innern der Bausteine durchgeführt werden. Als für diese Zwecke besonders geeignet haben sich die in allen Bereichen der Entwicklung und Fertigung mikroelektronischer Bauelemente eingesetzten ElektronenstrahlMeßverfahren herausgestellt. Die in der Praxis gebräuchlichsten Verfahren sind dem Fachmann beispielsweise aus der Veröffentlichung von H.P. Feuerbaum "Electron Beam Testing: Methods and Applications", Scanning, Vol. 5, Seiten 14-24 (1983) bekannt. Besonders aufschlußreiche Hinweise zur Lokalisierung von Fehlern in hochintegrierten Schaltungen erhält man durch quantitative Messungen des zeitlichen Potentialverlaufes an ausgewählten Knotenpunkten des untersuchten Bauelementes. Bei diesem beispielsweise aus der Veröffentlichung von H.P. Feuerbaum "VLSI Testing using the Electron Probe", Scanning Electron Microscopy, 1979/1, Seiten 285 bis 296 bekannten Verfahren wird der in der elektronenoptischen Säule eines modifizierten Rasterelektronenmikroskopes erzeugte Primärelektronenstrahl auf einem Meßpunkt positioniert und die vom Potential des Bauelementes abhängige Verschiebung der Energieverteilung der am Meßpunkt ausgelösten Sekundärelektronen in einer Spektrometer-Detektoranordnung bestimmt. Quantitative Messungen des Potentialverlaufes mit einer Zeitauflösung im Nano-Sekundenbereich sind nur stroboskopisch nach dem Sampling-Prinzip möglich. Bei diesem aus der elektrischen Meßtechnik bekannten Verfahren wird der Primärelektronenstrahl synchron mit der Frequenz des zu messenden Signals gepulst und der Potentialverlauf durch Verschieben des Eintastzeitpunktes der Primärelektronenpulse kontinuierlich aufgezeichnet. Eine hohe Zeitauflösung ist bei diesen Meßverfahren durch kurze Primärelektronenpulse erreichbar. Mit abnehmender Pulsdauer nimmt aber auch der am Ausgang der Spektrometer-Detektoranordnung anliegende Signalpegel sehr stark ab, so daß an die Meßelektronik hohe Anforderungen gestellt werden müssen. Da die Primärelektronenpulse bei den mit konventionellen Strahlaustastsystemen erreichbaren Pulsbreiten von 100 ps und Sondenströmen von 1 nA statistisch weniger als ein Elektron enthalten, erfordert die üblicherweise durchgeführte Strommessung extrem hohe Verstärkungen. Die Nachweisempfindlichkeit, die die kürzeste, noch zu einem auswertbaren Signal führende Pulsdauer und damit die mögliche Zeitauflösung bestimmt, versucht man deshalb mit Hilfe empfindlicher Detektoren und Elektronenquellen mit hoher Richtstrahlcharakteristik weiter zu steigern. Aber selbst bei Anwendung von Sample-and-Hold-Verfahren begrenzt letztendlich das hochverstärkte Rauschen der elektronischen Komponenten die erreichbare Nachweisgrenze und damit die maximal mögliche Zeitauflösung.

Der vorliegenden Erfindung liegt die Aufgabe zugrunde, ein Verfahren und eine Anordnung der eingangs genannten Art anzugeben, mit dem der Einfluß des Rauschens der elektronischen Komponenten eines Korpuskularstrahl-Meßgerätes auf die mit diesen System erreichbare Zeitauflösung nahezu vollständig unterdrückt werden kann.

Diese Aufgabe wird erfindungsgemäß durch ein Verfahren nach Patentanspruch 1 und eine Anordnung nach Patentanspruch 6 gelöst.

Der mit der Erfindung erzielbare Vorteil besteht insbesondere darin, daß die Zeitauflösung im wesentlichen durch die Primärelektronen-Pulsdauer und nicht durch das Rauschen der elektronischen Komponenten bestimmt wird. Es ist außerdem sichergestellt, daß eine erfindungsgemäße Anordnung zur Durchführung des Verfahrens sehr einfach in die Meßelektronik konventioneller Testsysteme integriert werden kann.

Während die Patentansprüche 2 bis 4 bevorzugte Ausgestaltungen und Weiterbildungen des erfindungsgemäßen Verfahrens betreffen, sind die Ansprüche 6 bis 8 auf vorteilhafte Anordnungen zur Durchführung des Verfahrens gerichtet.

Die Erfindung wird nachfolgend anhand der Zeichnung näher erläutert, in der ein Ausführungsbeispiel einer Anordnung zur Durchführung des erfindungsgemäßen Verfahrens dargestellt ist.

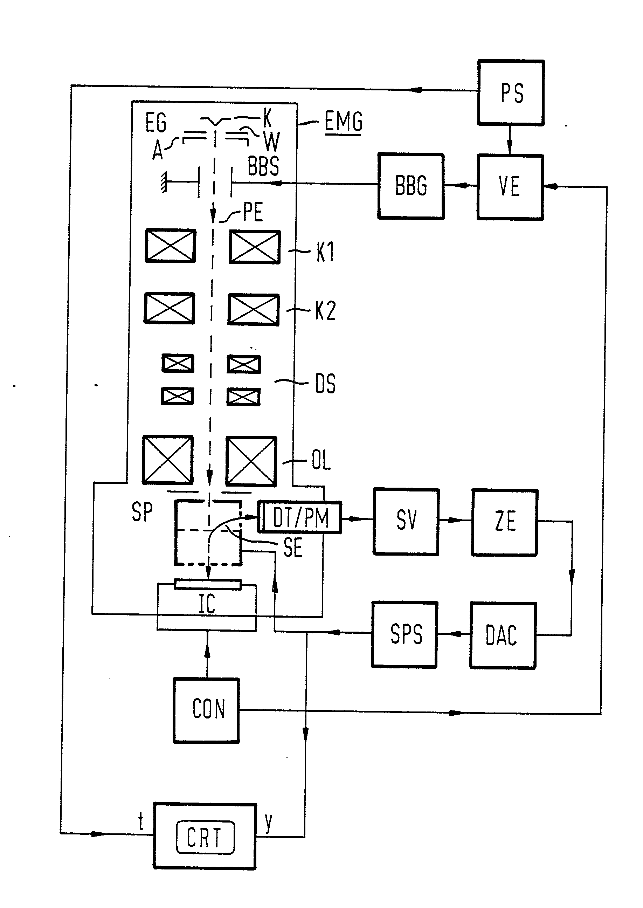

Bei der in Fig. 1 dargestellten Anordnung zur Messung zeitabhängiger Signale wird eine zu untersuchende Probe IC mit dem in der elektronenoptischen Säule eines Elektronenstrahl-Meßgerätes EMG erzeugten Primärelektronenstrahl PE abgetastet. Die elektronenoptische Säule besteht im wesentlichen aus einem Elektronenstrahlerzeuger EG, mehreren Linsensystemen zur Strahlformung, Strahlablenkung und Strahlfokussierung und einer Reihe nicht dargestellter Aperturblenden, die die auf achsenfernen Bahnen laufenden Primärelektronen PE ausblenden und so zur Verbesserung der Abbildungseigenschaften beitragen. Die von der Kathode K emittierten und in Richtung der Anode A beschleunigten Elektronen werden von der Wehnelt Elektrode W in einen ersten Strahlüberkreuzungspunkt fokussiert. Zur Erzeugung eines feinen Primärelektronenstrahles PE wird dieses Quellenbild der Kathode K anschließend mit Hilfe der Kondensorlinsen K1 und K2 und der Objektivlinse OL stark verkleinert auf die zu untersuchende Probe IC abgebildet, wobei sich die Bahnen der Primärelektronen PE nach Durchlaufen der von den einzelnen Linsensystemen aufgebauten Magnetfelder in weiteren Strahlüberkreuzungspunkten schneiden. In einem dieser Strahlüberkreuzungspunkte wird vorteilhafterweise ein über einen Pulsgenerator BBG angesteuertes Strahlaustastsystem BBS angeordnet. Wegen der Forderung nach Justierbarkeit des Strahlaustastsystems BBS kann man diese zumeist aus Kondensatorplatten bestehende Anordnung wie in Fig. 1 dargestellt allerdings oft nur zwischen Elektronenstrahlerzeuger EG und erster Kondensorlinse K1 installieren.

Die Positionierung des Primärelektronenstrahls PE auf einen nicht näher bezeichneten Punkt der Probe IC bzw. dessen zeilenförmige Ablenkung über die Probenoberfläche erfolgt mit Hilfe der Ablenkeinheit DS, die über einen nicht dargestellten Rastergenerator mit Ablenkspannung versorgt wird. Zum Nachweis der an einem Punkt der Probe IC von den hochenergetischen Primärelektro nen PE aufgrund ihrer Wechselwirkung mit der Festkörpersubstanz ausgelösten Sekundärelektronen SE ist beispielsweise ein aus Abschirmgitter, Szintillator und Lichtleiter bestehendes Detektorsystem DT mit nachgeschaltetem Photomultiplier PM vorgesehen. Der in dem Detektorsystem DT nachweisbare und aufgrund des statistischen Charakters des Auslöseprozesses - schwankende Sekundärelektronenstrom erzeugt im Szintillator Lichtimpulse, die im Photomultiplier PM in ein sekundäres elektrisches Signal umgewandelt werden. Dem Detektorsystem DT ist ein zwischen der Objektivlinse OL und der Probe IC angeordnetes Spektrometer SP, vorzugsweise ein elektrostatisches Gegenfeld-Spektrometer zur Messung der vom Probenpotential abhängigen Verschiebung der Energieverteilung der Sekundärelektronen SE vorgeschaltet. Diese aus dem Stand der Technik bekannnten GegenfeldSpektrometer SP bestehen zumeist aus einem Absaugnetz, einer oder mehreren ebenen oder halbkugelförmigen Gegenfeldelektroden und einer Ablenkelektrode zur Beschleunigung der Sekundärelektronen SE in Richtung des Szintillators.

Als Probe IC ist vorzugsweise eine integrierte Schaltung vorgesehen, in die man geeignete Testprogramme über die Probenansteuerung CON einspeist. Entsprechend der Schaltungsstruktur der Probe IC treten dann während des Testzyklus charakteristische, den jeweiligen Betriebszustand definierende Signale an Knotenpunkten und Leiterbahnen auf, deren Zeitverhalten mit dem Primärelektronenstrahl PE bestimmt und mit den aus Simulationsrechnungen gewonnenen Signalverläufen verglichen werden kann. Der zeitliche Verlauf eines hochfrequenten Signales kann in einem Elektronenstrahlmeßgerät EMG zur Zeit nur mit Hilfe des aus der elektrischen Meßtechnik bekannten Sampling-Verfahrens gemessen werden. Bei diesem Verfahren positioniert man den Primärelektronenstrahl PE auf einem Punkt der Probe IC und steuert den Pulsgenerator BBG über die Probenansteuerung CON und eine dem Pulsgenerator BBG vorgeschaltete Verzögerungseinheit VE so an, daß der Primärelektronenstrahl PE synchron mit dem zu messenden Signal eingetastet wird. Ist das Meßsignal mit dem erforderlichen Signal-Rausch-Abstand ermittelt, ändert man die Phasenlage der Primärelektronenpulse bezüglich des Meßpunktpotentials mit Hilfe des die Verzögerungseinheit VE ansteuernden Phasenschiebers PS. Durch kontinuierliches Verschieben des Eintastzeitpunktes der Primärelektronenpulse kann damit der an einem Meßpunkt anliegende zeitliche Potentialverlauf bestimmt und beispielsweise auf dem Bildschirm eines Sichtgerätes CRT dargestellt werden. Während die Y-Achse des Sichtgerätes CRT das mit Hilfe des Spektrometers SP und einer die Spannungsdifferenz zwischen Probe IC und Gegenfeldelektrode konstant haltenden Rückkopplungsschaltung bestimmte Meßpunktpotential präsentiert, wird die X-Ablenkung (Zeitachse) über die Sägezahnspannung des Phasenschiebers PS definiert.

Um hochfrequente Signalverläufe mit der geforderten Zeitauflösung messen zu können, ist man gezwungen mit sehr kurzen Primärelektronenpulsen zu arbeiten. Bei den mit modernen Strahlaustastsystemen erreichbaren Pulsbreiten unter 100 ps bedeutet dies aber, daß ein Primärelektronenpuls bei Strahlenströmen von 1 nA statistisch nur noch etwa 0.6 Elektronen enthält. Da die Sekundärelektronen-Ausbeute ihrerseits wiederum nur in der Größenordnung von 1 liegt, werden in dem Detektorsystem DT nur einzelne, statistisch auftretende Sekundärelektronen SE registriert, die am Ausgang des unter diesen Bedingungen nicht integrierenden Photomultipliers PM Stromimpulse mit unterschiedlicher Amplitude und unterschiedlichem Zeitverhalten erzeugen. Die in konventionellen Anordnungen durchgeführten Strom messungen sind aber nur bei einem mit konstantem Verstärkungsfaktor arbeitenden Photomultiplier PM, also bei hohem Sekundärelektronenströmen, ohne größeren Aufwand und hohe Verstärkungen durchführbar. Mit der in Fig. 1 dargestellten Anordnung werden diese Schwierigkeiten umgangen, indem man keine Strommessung durchführt, sondern die Zahl der innerhalb eines vorgegebenen Zeitintervalls am Ausgang des Photomultipliers PM auftretenden Stromimpulse mit einer über einer einstellbaren Schwelle liegenden Amplitude in einem handelsüblichen Impulszähler ZE bestimmt. Dem Impulszähler ZE kann vorteilhafterweise noch eine Signalverarbeitung SV vorgestaltet sein, in der das Photomultiplier-Ausgangssignal verstärkt und einer Filterung zur Verbesserung des Signal-Rausch-Verhältnisses unterworfen wird. Dem Impulszähler ZE ist ein die Spektrometerversorgung SPS ansteuernder Digital-Analog-Wandler DAC nachgeschaltet, der das der Zahl $\Delta N$ der innerhalb des vorgegebenen Zeitintervalls $\Delta t$ gemessenen Stromimpulse $\Delta N/\Delta t$ entsprechende digital Signal in ein analoges Signal umwandelt. Bei der erfindungsgemäßen Anordnung wird also nicht der am Ausgang des Photomultipliers PM gemessene Strom sondern die Zahl $\Delta N$ der innerhalb eines Zeitintervalls $\Delta t$ registrierten und von einzelnen Elektronen erzeugten Stromimpulse über die aus Impulszähler ZE, Digital-Analog-Wandler DAC und Spektrometeransteuerung SPS bestehende Rückkopplungsschaltung durch Nachregeln der Spannung der Gegenfeldelektrode konstant gehalten. Um die innerhalb des Zeitintervalls $\Delta t$ auftretenden Stromimpulse voneinander trennen zu können, müssen in der erfindungsgemäßen Anordung schnelle Photomultiplier und Szintillatoren mit kurzen Abklingzeiten eingesetzt werden.

Um die durch Strahlstromschwankungen verursachten Meßfehler zumindest teilweise zu korrigieren ist es vorteilhaft, die Zahl der innerhalb eines vorgegebenen Zeitintervalls $\Delta t$ gezählten Stromimpulse $\Delta N/\Delta t$ auf die Zahl der innerhalb dieses Zeitintervalls $\Delta t$ auf die Probe IC auftreffenden Primärelektronen $\Delta N_{PE}$ zu bezie hen und den aus diesen Meßgrößen bestimmten Quotienten $\Delta N/\Delta N_{PE}$ konstant zu halten. Die Zahl der innerhalb des Zeitintervalles $\Delta t$ auf die Probe IC auftreffenden Primärelektronen PE kann beispielsweise über die in einem Detektor gemessenen Rückstreuelektronen bestimmt werden.

Die Erfindung wurde bisher am Beispiel eines Elektronenstrahlmeßgerätes beschrieben. Ihre Anwendung ist selbstverständlich nicht auf solche Geräte beschränkt. Sie kann vielmehr in jedem Meßgerät, in dem ein primärer Korpuskularstrahl Sekundärkorpuskeln auf einer Probe auslöst, eingesetzt werden.

### Ansprüche

1. Verfahren zur Messung zeitabhängiger Signale mit einer Korpuskularsonde, die auf mindestens einem ein zeitabhängiges Signal führenden Meßpunkt fokussiert und synchron zu dem anliegenden Signal eingetastet wird, bei dem die von dem Meßpunktpotential abhängige Verschiebung der Energieverteilung der von der Korpuskularsonde ausgelösten Sekundärkorpuskeln in einem Energieanalysator bestimmt wird, und bei dem ein an dessen Ausgang gemessenes Signal über eine den Energieanalysator ansteuernde Rückkopplungsschaltung konstant gehalten und ein hieraus abgeleitetes Signal aufgezeichnet wird, dadurch **gekennzeichnet**, daß die von den in dem Energieanalysator (SP, DT, PM) registrierten Sekundärkorpuskeln (SE) ausgelösten Stromimpulse gezählt werden, daß die Zahl ($\Delta N$) der an einem Ausgang des Energieanalysators (SP, DT, PM) innerhalb eines vorgegebenen Zeitintervalls - ($\Delta t$) gemessenen Stromimpulse bestimmt und die Zahl der Stromimpulse pro Zeiteinheit ($\Delta N/\Delta t$) über die Rückkopplungsschaltung (ZE, DAC, SPS) konstant gehalten wird.

2. Verfahren nach Anspruch 1, dadurch **gekennzeichnet**, daß die Zahl ($\Delta N$) der innerhalb des vorgegebenen Zeitintervalls ($\Delta t$) gemessenen Stromimpulse auf die Zahl ($\Delta N_{PE}$) der innerhalb dieses Zeitintervalls ($\Delta t$) auf dem Meßpunkt auftreffenden Primärkorpuskeln (PE) normiert wird und daß der Quotient ($\Delta N/\Delta N_{PE}$) aus der Zahl der Stromimpulse und der Zahl der auftreffenden Primärkorpuskeln (PE) über die Rückkopplungsschaltung (ZE, DAC, SPS) konstant gehalten wird.

3. Verfahren nach Anspruch 1 oder 2, dadurch **gekennzeichnet**, daß die Zahl ($\Delta N_{PE}$) der innerhalb des vorgegebenen Zeitintervalls ($\Delta t$) auf dem Meßpunkt auftreffenden Primärkorpuskeln (PE) über die Zahl der innerhalb des Zeitintervalls ($\Delta t$) registrierten rückgestreuten Primärkorpuskeln bestimmt wird.

4. Verfahren nach einem der Ansprüche 1 bis 3, dadurch **gekennzeichnet**, daß ein der Zahl der pro Zeiteinheit gemessenen Stromimpulse repräsentierendes digitales Signal in ein analoges Signal umgewandelt und zur Steuerung des Energieanalysators (SP, DT, PM) herangezogen wird.

5. Verfahren nach einem der Ansprüche 1 bis 4, dadurch **gekennzeichnet** , daß die Zahl (ΔN) der von einem Photomultiplier (PM) erzeugten Stromimpulse pro Zeiteinheit bestimmt wird.

6. Anordnung zur Durchführung des Verfahrens nach Anspruch 1 mit einem Primärstrahlerzeuger, einem Strahlaustastsystem, einem Energieanalysator, einer Verstärkerschaltung und einer Rückkopplungsschaltung, dadurch **gekennzeichnet**, daß dem Energieanalysator (SP, DT, PM) ein Impulszähler (ZE) und ein Digital-Analog-Wandler - (DAC) nachgeschaltet ist.

7. Anordnung nach Anspruch 6, **gekennzeichnet** durch ein elektrostatisches Gegenfeld-Spektrometer (SP) mit zugeordnetem Detektorsystem - (DT) als Energieanalysator.

8. Anordnung nach Anspruch 6 oder 7, dadurch **gekennzeichnet**, daß dem Detektorsystem (DT) ein Photomultiplier (PM) nachgeschaltet ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| A | ELECTRONICS INTERNATIONAL, Band 54, Nr. 14, 14. Juli 1981, Seiten 105-112, New York, US; P. FAZEKAS et al.: "Scanning electron beam probes VLSI chips" * Seite 107, linke Spalte: "Sampling a microscope"; Seite 109, linke Spalte, Absatz: "Voltage measurement" - Ende Absatz, rechte Spalte; Abbildungen 1,5 * | 1,6 | G 01 R 31/28 |
| | --- | | |
| A | IEEE JOURNAL OF SOLID-STATE CIRCUITS, Band SC-13, Nr. 3, Juni 1978, Seiten 319-325, IEEE, New York, US; H.-P. FEUERBAUM et al.: "Quantitative measurement with high time resolution of internal waveforms on MOS RAM's using a modified scanning electron microscope" * Insgesamt * | 1,6-8 | |
| | | | RECHERCHIERTE SACHGEBIETE (Int. Cl.4) |
| | --- | | G 01 R |
| A | EP-A-0 156 006 (SIEMENS) | | |
| | --- | | |
| A | EP-A-0 014 304 (SIEMENS) | | |
| | ----- | | |

Der vorliegende Recherchenbericht wurde für alle Patentansprüche erstellt.

| Recherchenort DEN HAAG | Abschlußdatum der Recherche 20-05-1987 | Prüfer KUSCHBERT D.E. |
|---|---|---|